# EUROPEAN PATENT APPLICATION

(11) **EP 0 544 399 A2**
(43) Date of publication of application: **02.06.1993**
(21) Application number: 92309403.1
(22) Date of filing: 15.10.1992
(51) Int. Cl.: H01L 21/20, H01L 21/316, H01L 39/24, C30B 23/02

(54) **Epitaxial magnesium oxide as a buffer layer for formation of subsequent layers on tetrahedral semiconductors**

(30) Priority: 26.11.1991 US 798672
(71) Applicant: XEROX CORPORATION, Rochester New York 14644 (US)
(72) Inventor: Fork, David K., Palo Alto, California 94306 (US); Nashimoto, Keiichi, Ayase, Kanagawa 252 (JP)
(74) Representative: Reynolds, Julian David

(57) **Abstract**

A structure includes a semiconducting substrate (12;22;32) on which is formed an epitaxial buffer layer (14;24;34) of MgO and an epitaxial layer (16;26;38) of ferroelectric material or superconducting material or both. The semiconducting substrate (12;22;32) is of the tetrahedral structure type, and may be an elemental or compound material. The MgO buffer layer (14;24;34) on the tetrahedral semiconducting substrate allows epitaxial formation of the subsequent layers, facilitating the formation of a number of novel monolithic devices.

## Description

The present invention relates generally to the epitaxial formation of one or more layers of material on a substrate of a dissimilar material. Specifically, the invention relates to the formation of epitaxial MgO buffer layers on tetrahedral semiconductor substrates, specifically elemental substrates such as Ge, and compound substrates such as GaAs, in order to facilitate the formation of an additional epitaxial layer or layers on the MgO/tetrahedral semiconductor substrate structure.

Presently, there is much research being done in the field of forming oxides on semiconductor substrates. A particularly active area in this field, and one with important technological applications, is the formation of oxides on semiconductor substrates by epitaxy. Substrate as used herein refers in general to an underlying layer, including but not limited to the base layer upon which other layers are formed. Epitaxy as used herein refers to the alignment of a thin crystalline film with its crystalline substrate, where the film and the substrate may be different materials with different crystal structures. In the absence of epitaxy, the crystalline thin film will consist of many small crystallites which are each oriented randomly with respect to the substrate.

There are many materials which could form the basis of important technologies if epitaxially formed on selected substrates. Ferroelectric materials, which are the electrical analog of ferromagnetic materials in the sense that they can sustain a permanent electric dipole moment, are one such material. Much attention has recently been devoted to the use of ferroelectric thin films for nonvolatile memories (memories which retain their information when power is removed), electro-optic devices, and surface acoustic wave devices. Epitaxial growth of ferroelectric films is important in preparing useful, high quality films because the properties of ferroelectric materials depend on their crystallographic orientation. In nonvolatile memories, the permanent ferroelectric dipole moment in one device is used to store one bit of information. The dipole moment is enhanced when the ferroelectric is epitaxial, because the dipoles can all align in the same direction. This is not the case in a non-epitaxial film because the crystallites are randomly oriented. It is a property of nature that all ferroelectric crystals change shape when an electric field is applied. In nonvolatile ferroelectric memories, this shape change can produce internal stresses which limit the lifetime of the device. By growing the ferroelectric film epitaxially and applying the electric field normal to the surface, the stress can be reduced or eliminated altogether because the distortion of the crystal occurs normal to the free surface of the film.

Whereas epitaxial ferroelectric films are an enhancement to nonvolatile memories, epitaxial ferroelectric films are essential for electro-optic applications using optical waveguides because of the requirement for low optical propagation loss. It is known that the index of refraction of ferroelectric crystals depends on the crystal orientation. A non-epitaxial ferroelectric thin film will have a large propagation loss due to scattering because at each grain boundary a change in index of refraction (caused by the change in orientation) is encountered. However, an epitaxial ferroelectric thin film will have significantly less propagation loss, and a variety of applications therefore become possible. For example, a practicable ferroelectric waveguide may be obtained on a GaAs substrate containing a semiconductor laser if the ferroelectric waveguide layer is epitaxially formed. Also, the well known piezoelectric property of ferroelectric materials, that is their distortion in an applied electric field, makes it possible to generate acoustic waves which diffract or direct the laser beam by virtue of the varying index of refraction. The nonlinear properties of ferroelectrics make it possible to, for example, double the frequency of the laser light and produce a variety of colors. The electro-optic effect, the variation in the index of refraction with an applied electric field, makes it possible to modulate the laser light.

Another group of materials which could form the basis of important technologies if epitaxially formed on selected substrates are high temperature superconductors. Certain high temperature superconducting crystalline compounds, which take the form of various copper oxides, have electrical properties which depend significantly on their crystal orientations. For example, the critical current density, which is the amount of current that the material may carry with negligible resistance, is generally large when current flows along the copper-oxygen planes, and is quite small when current flows normal to the copper-oxygen planes. Accurate figures are presently not known, but the anisotropy is believed to be one thousand to one or more is some cases. Epitaxial films of the high temperature superconductors typically have large critical current densities for current passing in the copper-oxygen planes whereas nonepitaxial films heretofore have not been capable of sustaining large critical currents. In the non-epitaxial films, each grain boundary becomes a "weak-link" in the conduction path because the copper-oxygen planes do not line up favorably. The electrical characteristics of the high temperature superconducting oxide films at high frequencies are very dependent on their crystal quality due largely to the "weak-link" problem. Epitaxial growth is an essential requirement to obtaining films suitable for microwave applications. When epitaxial films of sufficient quality are grown, their losses at 10 GHz can be orders of magnitude lower than copper at 77 K.

There are, in fact, applications where both high temperature superconductors and ferroelectric materials are employed together in one device. One example is the use of high temperature superconductors as electrodes for ferroelectric devices. These devices have the advantage over those with ordinary metal electrodes, such as gold, platinum and aluminum, that oriented epitaxial growth of the ferroelectric is possible, with the benefits noted above. In this application, the metallic, not the superconducting, property of the cuprate superconductors is exploited. Using the cuprate as the bottom electrode and a metal or cuprate as the top electrode, a capacitor structure is produced in which an applied voltage may be used to switch the polarization of the epitaxial ferroelectric to store one bit of data per capacitor. The device is read by reversing the polarization and monitoring the resultant pulse of current.

A very important class of devices are those whose substrate is a semiconductor, especially a compound semiconductor. The use of a compound semiconducting substrate is important because it enables the monolithic combination of many types of semiconductor devices, including transistors, capacitors, resistors, diodes, lasers, etc., with elements and components comprised of superconductors and/or ferroelectrics. For example, epitaxial growth of ferroelectric films on GaAs would allow the integration of semiconductor lasers and oxide ferroelectric electro-optic devices on the same GaAs substrate.

Formation of epitaxial layers of ferroelectric materials and/or superconductive materials on a silicon substrate have been demonstrated. Other epitaxial ferroelectric and high temperature superconducting films on non-semiconducting oxide substrates have been reported, for example, PLZT thin films on GaAs and GaP. These films have proven less than acceptable for device configurations based at least on the problem of diffusion of Pb into the substrate. However, as yet unreported are practical epitaxial ferroelectrics and high temperature superconductors grown on elemental semiconducting substrates other than silicon, and on compound semiconducting substrates.

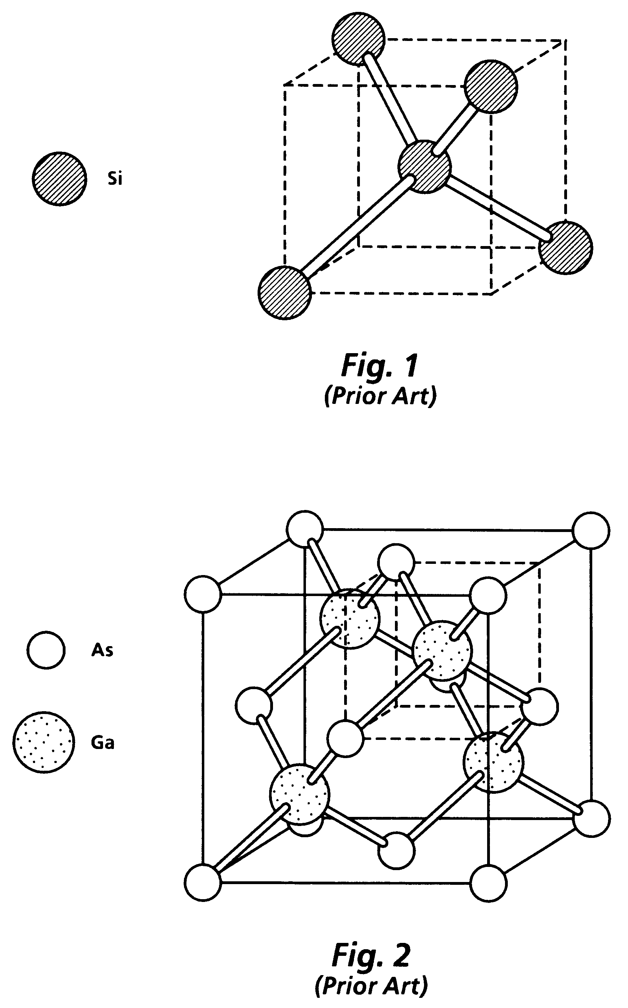

There are a number of semiconductor materials that might form the substrates alluded to above, many of which share essentially the same crystal structure. One important class of semiconductors are those in which each atom is surrounded by four tetrahedrally arranged nearest neighbors. These semiconductors are collectively referred to herein as tetrahedral semiconductors. Diamond, silicon and germanium, are elemental semiconductors which have a tetrahedral crystal structure and are viable materials for semiconducting electronics. As an example of the tetrahedral structure of an elemental semiconductor, the atomic structure of silicon is shown in Fig. 1. Elemental tetrahedral semiconductors are covalent. Tetrahedral compound (or alloy) semiconductors are those in which the atomic lattice of the compound is arranged such that each atom is surrounded by four nearest neighboring atoms in a tetrahedral pattern. Examples of tetrahedral compound semiconductors include SiC and its polytypes (based on having each carbon tetrahedrally coordinated by Si and visa versa), GaAs, and other compound semiconductors generally compounded from columns III and V or rows II and VI of the periodic table. As an example of the tetrahedral structure of a compound semiconductor crystal, the structure GaAs is shown in Fig. 2. Compound semiconductors have a mixture of covalent and ionic character. The intermediate class of alloyed elemental tetrahedral semiconductors is also of interest. An example of this type of material is silicon alloyed with germanium. The crystal structure of these materials are disordered. However, they may still serve as useful substrates for various devices.

Epitaxy of ferroelectric films directly on GaAs (as an example of a tetrahedral semiconductor) is rendered difficult by several factors including the high growth temperature required, interdiffusion, and the general lack of epitaxy to the zinc blend structure. When, for example, ferroelectric PLZT [(Pb,La)(Zr,Ti)₃] films were prepared on GaAs, diffusion of Pb into the GaAs was detected. (See the previously referred to reference of Ishida et al.) The high temperature process required for the growth of ferroelectric films will also decompose GaAs devices. GaAs begins to loose As above 400°C, and layer by layer sublimaton has been reported above 690°C without an As₄ flux atmosphere which is not compatible with ferroelectric or superconductor film growth.

Much the same can be said with regard to the formation of high temperature superconductor films formed directly on tetrahedral semiconductor substrates. The high temperature process required for the growth of the superconductor films will decompose the semiconductor devices. Although not all combinations of the cuprate superconductors with the tetrahedral semiconductors have been tested for thin film compatibility, those systems tested to date react to form undesirable insulating products.

One successful solution to overcome the difficulties of mating a ferroelectric and/or superconducting thin film with an elemental silicon substrate is the use of a capping buffer layer. This buffer layer is formed epitaxially at low temperature, and is of a type which promotes epitaxial growth of ferroelectric and/or superconducting films while at the same time preventing diffusion from the ferroelectric and/or superconducting films into the substrate. As will be described herein, the present invention overcomes the limitation of the prior art by providing a metal, epitaxial ferroelectric and/or superconducting film on a tetrahedral elemental semiconductor substrate of a material other than silicon, or on a tetrahedral compound semiconductor substrate, having an MgO buffer layer formed therebetween.

The present invention provides a structure according to claim 1, and a method according to claim 10, of the appended claims.

The present invention enables the production of useful monolithically integrated structures of dissimilar materials heretofore incapable of being usefully integrated, and devices resulting from and employing such integration. In general, the present invention provides a variety of structures of the type having metal, epitaxial ferroelectric material, epitaxial superconducting material or combinations of one or more of these materials formed on a magnesium oxide (MgO) layer, which in turn is epitaxially formed on a tetrahedral semiconductor substrate. The structures provided by the present invention extend beyond the known silicon substrate to elemental semiconductor substrates other than silicon, and to compound semiconductor substrates. The method of the present invention, in general, facilitates fabrication of new structures employing tetrahedral compound semiconductor substrates.

MgO is neither ferroelectric nor superconducting. It is however an excellent substrate for the epitaxial growth of both of these classes of materials. When grown as an epitaxial thin film, the thin film layer is also an excellent substrate for metal, ferroelectric and/or oxide superconductor layers. Key to this invention therefore is the use of MgO as an epitaxial buffer layer on semiconductor substrates. As an epitaxial buffer layer, the MgO has its crystallographic axes aligned with those of the substrate, and furthermore, transmits the alignment such that the crystallographic axes of subsequently formed layers also align with those of the substrate.

Certain embodiments of the present invention may utilize the buffer layer for additional purposes. For example, waveguides could further utilize the MgO buffer layer as a means for additional light confinement (e.g, to ensure that light in the ferroelectric is confined by total internal reflection).

One particularly important subset of the structures capable of being produced according to the present invention are structures of either ferroelectric or superconducting material formed on semiconductor substrates of the type having light emitting or similar devices formed therein, for example GaAs substrates having solid state lasers formed therein. This invention provides the only currently known method for obtaining the combination of GaAs substrates with epitaxial films of the superconducting cuprates.

Another particularly important subset of the structures capable of being produced according to the present invention involve the formation of an intermediate layer of, for example BaTiO₃, between the magnesium oxide layer and a layer of superconducting material, all on a tetrahedral semiconductor substrate such as GaAs. Improved epitaxy is obtained for the superconducting material, which leads to devices having improved electrical properties.

While MgO is the focus of the present work, it is believed that the other group II oxides (CaO₂, SrO₂, BaO₂, etc.) will provide the same or similar benefits as MgO. A deciding factor in choosing MgO from among the various possible oxides for formation on semiconductor substrates is that, using the methods herein disclosed, crystalline MgO may be formed epitaxially at very low temperatures. We have produced epitaxial MgO on GaAs at temperatures below 250° Celsius. This has the advantage of making it possible to form the MgO layers at temperatures well below the temperatures at which GaAs begins to loose arsenic (about 400° Celsius). Once the MgO layer is formed, the GaAs is capped, and other layers requiring high formation temperatures may safely be formed. MgO is a large band gap insulator with the NaCl structure. The index of refraction of MgO is 1.7, which is smaller than most oxide ferroelectrics, which is a requirement for making optical transmission lines. The lattice constant of MgO is 4.213 Å, implying a large mismatch to semiconductors such as GaAs. However, our research has shown that the lattice constant does not have a large impact on the epitaxial growth of MgO on a tetrahedral semiconductor substrate. Furthermore, we have also shown that MgO, which is highly ionic, will grow epitaxially both on purely covalent tetrahedral semiconductors such as silicon, and partially ionic tetrahedral semiconductors such as GaAs.

Embodiments of the present invention will now be described, by way of example, with reference to the accompanying drawings, in which:
Fig. 1 shows an example of the tetrahedral structure of an elemental semiconductor, silicon, as known in the art;
Fig. 2 shows an example of the tetrahedral structure of an compound semiconductor, GaAs, as known in the art;
Fig. 3 shows a structure according to one embodiment of the present invention in which a film of BaTiO₃ is epitaxially formed on a layer of MgO on a tetrahedral semiconductor substrate.
Fig. 4 shows a structure according to another embodiment of the present invention in which a film of YBCO is epitaxially formed on a layer of MgO on a tetrahedral semiconductor substrate; and
Fig. 5 shows a structure according to yet another embodiment of the present invention in which a film of YBCO is epitaxially formed on a layer of BaTiO₃, which itself is epitaxially formed on a layer of MgO on a tetrahedral semiconductor substrate.

The scope of the present invention and the manner in which it overcomes the deficiencies in the prior art will become more readily apparent from the following detailed description when taken in conjunction with these drawings.

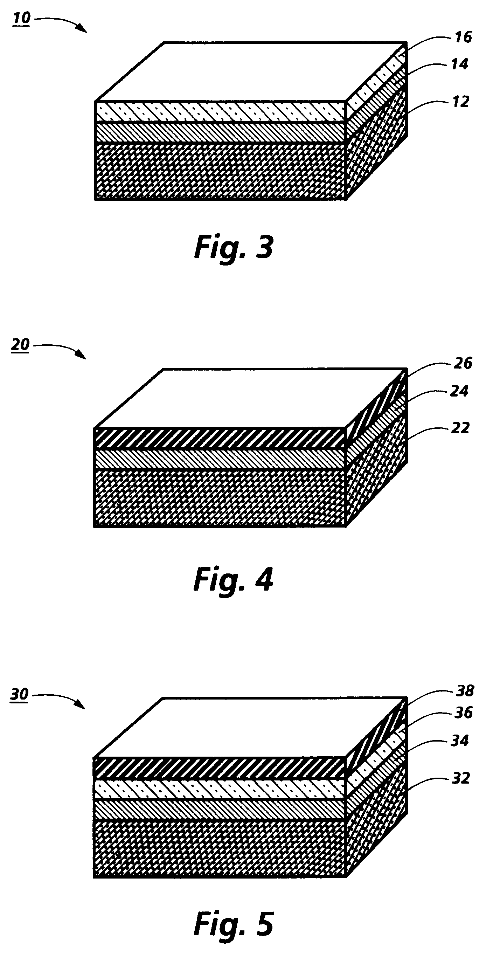

The present invention will be described by way of examples, with areas of generalization referenced where appropriate. Fig. 3 shows in perspective view a structure 10 which will serve as a first example. (It will be noted that Fig. 3, as well as all figures herein, are not to scale unless otherwise indicated.) Structure 10 comprises a substrate 12 of (001) GaAs on which is formed an epitaxial layer of MgO 14. On MgO layer 14 is formed a thin epitaxial film of ferroelectric BaTiO₃ 16. Importantly, BaTiO₃ films deposited in various conditions directly on GaAs were not epitaxial to GaAs in our experiments. By first growing MgO on the GaAs surface, we have produced epitaxial BaTiO₃ under a wide range of growth conditions.

The film depositions were carried out by pulsed laser ablation with a 308 nm XeCl excimer laser at a pulse rate of 4 Hz, a pulse length of 17 ns, and a laser energy of 130 mJ which gave an energy density of 1.3 J/cm² on the targets. The target-to-substrate distance was 50 mm. BaTiO₃ and Mg targets were used. An Mg metal target was used since the light absorption of MgO at 308 nm is too weak to ablate the oxide (MgO). Mg from the Mg metal target is oxidized very easily by O₂ due to the MgO molecule's high binding energy, exceeding 10 eV. The GaAs substrate was heated by quartz lamp radiation. Temperatures were measured by thermocouple near the lamp, which was always hotter than the substrate, and by a pyrometer which faced the substrate.

The Si doped GaAs (001) wafer was cleaned with commonly used solvents followed by etching in H₂SO₄:H₂O₂:H₂O. The substrate was then rinsed with deionized water and ethanol, and spin-dried with ethanol in a flowing N₂ hood. After this procedure, the substrate was immediately introduced into the deposition chamber. The substrate was heated at 680°C (600°C by the pyrometer) for 2 minutes at the base pressure, 3 × 10⁻⁷ Torr, before deposition of MgO films to sublimate surface oxides formed after etching. This temperature was selected based on the assumption that oxide desorption occurs at a temperature of 582°C.

MgO films were deposited on a number of samples at temperatures in the range of 250°C to 450°C and pressures in the range of 2 × 10⁻⁶ to 2 × 10⁻⁵ Torr O₂. Subsequent to the formation of the MgO layers on these samples, a BaTiO₃ film was deposited on each at a temperature in the range of 680 to 880°C (600 to 800 °C by the pyrometer) in an environment whose pressure ranged from 1 to 10 × 10⁻³Torr O₂. The deposition of the MgO and BaTiO₃ films on each sample were done in the same chamber during the same run.

X-ray ϑ-2ϑ diffraction patterns from BaTiO₃/MgO/GaAs structures showed that the MgO and BaTiO₃ layers grew epitaxially with their in plane [100] directions aligned to GaAs [100] and with their out of plane [001] directions aligned to GaAs [001]. Diffraction patterns corresponding only to these epitaxial relations were obtained when MgO films were prepared in 5 × 10⁻⁶ Torr O₂. (The best diffraction patterns corresponding to these epitaxial relations were obtained when MgO films were prepared in 5 × 10⁻⁶ Torr O₂.) Misoriented planes of BaTiO₃ were observed when the MgO films were deposited in O₂ pressure lower than 2 × 10⁻⁶ Torr. The degree of in-plane and out of plane misalignment of the epitaxial films with respect to the substrate was also measured using x-ray diffraction. Out of plane misalignment of MgO was as low as less than one degree. Out of plane misalignment of the BaTiO₃ was less than 1.5 degrees. In-plane film misalignments were generally less than 2 degrees. The full width at half maximum of rocking curves for BaTiO₃ (200) and MgO (200) were proportional to each other, indicating that the crystallinity of BaTiO₃ films depend on the quality of the underlying MgO films. Films without sublimation of surface oxides formed after etching were also prepared, and these showed approximately twice as much in-plane and out-of-plane misalignment to the GaAs substrate.

The refractive index of the MgO films was measured by ellipsometry. Values very close to the bulk value in films were obtained with the highest epitaxial quality (index of 1.725 compared to a bulk value of 1.735). Ferroelectric behavior in the BaTiO₃ films was verified by measuring the polarization versus applied electric field by use of a Sawyer-Tower circuit.

Fig. 4 details an example of a model high temperature superconductor structure 20 produced according to the present invention. Structure 20 includes a GaAs substrate 22 on which is formed layer 24 of MgO in a fashion such as that described above. The superconducting material YBa₂C₃O_{7-δ} (YBCO) was formed as an epitaxial film 26 on the MgO layer 24. The YBCO layer was grown at 800 to 850°C (700 to 750° C by the pyrometer) in 200 mTorr oxygen in the same chamber by the same pulsed laser deposition process. The epitaxy was verified by x-ray diffraction which indicated that the in-plane [100] directions of the layers were colinear, and that the YBCO films grew with their c-axis normal to the plane of the substrate. Superconductivity was verified by measuring the resistance versus temperature. The film lost its resistance at temperatures (T_{c}) as high as 87 K.

Fig. 5 details another example, similar to that shown in Fig. 4, of a model high temperature superconductor structure 30. Formed on GaAs substrate 32 were MgO layer 34 and BaTiO₃ layer 36 in a fashion similar to that described above. Layer 38 of YBa₂C₃O_{7-δ} (YBCO) was then formed on layer 36 as described above. Again, the epitaxy was verified by x-ray diffraction which indicated that the in-plane [100] directions of of the layers were colinear, and that the YBCO films grew with their c-axis normal to the plane of the substrate. Superconductivity was verified by measuring the resistance versus temperature. The film lost its resistance at temperatures (T_{c}) as high as 87 K.

Although several oxide buffer materials have been grown epitaxially on Si, this work represents the first report of an epitaxial oxide buffer layer on GaAs. Epitaxial MgO on both GaAs and on Si have now been produced. From this it is concluded that epitaxial MgO growth on all the tetrahedral semiconductors (of which Si and GaAs are two) is not only possible, but should occur at similarly low temperatures. The extension of the epitaxial growth procedure to compound tetrahedral semiconductor substrates such as ZnSe and InP and to the column 4 elemental tetrahedral semiconductors Ge and diamond may be made with predictable results. Since it is believed that epitaxy will occur regardless of the lattice constant of the semiconductor, the large differences in lattice constant among these materials does not affect this conclusion. The lattice mismatches of MgO to silicon and GaAs are large (22.5 and 25 % respectively), providing evidence that lattice match is not playing an important role in the establishment of epitaxial growth.

With a similar process to that described above, ABO₃ type perovskite thin films, such as PbTiO₃, PbLaTi₃ [PLT], Pb(ZrTi)₃ [PZT], (Pb,La)(Zr,Ti)₃ [PLZT], SrTiO₃, KNbO₃, KTaO₃, NaNbO₃, CaTiO₃, LaAlO₃, and NaTaO₃ can be grown epitaxially on Ge, diamond, cubic SiC, AlAs, AlSb, AlP, GaP, GaSb, InP, InAs, InSb, ZnS, ZnSe, ZnTe, CaSe, CdTe, HgSe, HgTe, CdS, AlGaP, AlInP, AlGaAs, AlInAs, AlAsSb, GalnAs, GalnSb, GaAsSb, and InAsSb substrates using low temperature grown epitaxial MgO buffer layers without causing damage to tetrahedral compound semiconductors. Also, any material which may be grown epitaxially on a single crystal MgO substrate may be grown on epitaxial MgO on these tetrahedral semiconductor substrates. We suggest that pulsed laser deposition is only one of a variety of suitable growth techniques. Others are known in the art, such as sputtering, electron beam deposition, molecular beam deposition, ion plating, chemical vapor deposition, etc., which should also work to prepare epitaxial MgO on tetrahedral semiconductors. With this technique, monolithically integrated devices including semiconductor laser diode and solid state acousto-optic laser scanner, and high temperature superconducting devices integrated with GaAs high frequency devices can be made, for the first time.

In general, to those skilled in the art to which this invention relates, many changes in construction and different embodiments and applications of the present invention will suggest themselves without departing from its scope. For example, the order of layers disposed on the buffer layer may be varied to accomplish specific purposes, as will be apparent to one skilled in the art. Also, substrate as used herein may be a layer of a structure formed yet another layer. For example, reference to structures having a semiconductive substrate will be understood by one skilled in the art to include structures where that semiconductive layer is, itself, formed on yet another layer of material. Thus, the disclosures and descriptions herein are to be viewed as illustrative, and not in any sense limiting.

## Claims

1. A structure comprising:
a tetrahedral compound semiconductor substrate (12;22;32); and
a layer (14;24;34) of epitaxial magnesium oxide grown on said substrate (12;22;32) such that its crystallographic axes are aligned with those of the tetrahedral compound semiconductor substrate.

2. The structure of claim 1, where:
(1) the substrate (a) is composed of a compound consisting of at least one element selected from column III and at least one element selected from group V of the periodic table of the elements; or (b) is selected from the group consisting of AlAs, AlSb, AlP, GaAs, GaP, GaSb, InP, InAs, InSb, AlGaP, AlInP, AlGaAs, AlInAs, AlAsSb, GalnAs, GalnSb, GaAsSb, and InAsSb; or
(2) the substrate (a) is comprised of cubic SiC, (b) is composed substantially of elemental Ge, or (c) is comprised of diamond; or
(3) the substrate (a) is composed of a compound consisting of at least one element selected from column II and at least one element selected from group VI of the periodic table of the elements; or (b) is selected from the group consisting of ZnS, ZnSe, ZnTe, CaSe, CdTe, HgSe, HgTe, and CdS.

3. The structure of claim 1 or 2, further including an epitaxial overlayer (16;26;38) formed on said layer (14;24;34) of epitaxial magnesium oxide.

4. The structure of claim 1, 2 or 3, further including an intermediate buffer layer (36) disposed between said layer (14;24;34) of epitaxial magnesium oxide and said epitaxial overlayer (16;26;38).

5. The structure of claim 4, wherein the material of said epitaxial overlayer (16;26;38) or said intermediate buffer layer (36) is a superconducting material, a ferroelectric material, an ABO₃ type perovskite thin film material or YBCO.

6. The structure of claim 5, wherein the ABO₃ type perovskite thin film material is selected from the group consisting of BaTiO₃, PbTiO₃, PbLaTi₃, Pb(ZrTi)₃, (Pb,La)(Zr,Ti)₃, SrTiO₃, KNbO₃, KTaO₃, NaNbO₃, CaTiO₃, LaAlO₃, and NaTaO₃

7. A structure according to claim 1, wherein:
the semiconductor substrate is composed of GaAs; and further comprising
an epitaxial overlayer of BaTiO₃ formed on said layer of epitaxial magnesium oxide such that its crystallographic axes are aligned with the axes of at least one of the substrate and the layer of epitaxial magnesium oxide.

8. A structure according to claim 1, wherein:
the semiconductor substrate is composed of GaAs; and further comprising
a first epitaxial overlayer of BaTiO₃ formed on said layer of epitaxial magnesium oxide such that its crystallographic axes are aligned with the axes of at least one of the substrate and the layer of epitaxial magnesium oxide; and
a second epitaxial overlayer of superconducting material formed on said first epitaxial overlayer such that its crystallographic axes are aligned with the axes of at least one of the substrate, the layer of epitaxial magnesium oxide, and the first epitaxial overlayer.

9. A structure according to claim 1, wherein:
the semiconductor substrate is composed of GaAs; and further comprising
a first epitaxial overlayer of superconducting material formed on said layer of epitaxial magnesium oxide such that its crystallographic axes are aligned with the axes of at least one of the substrate and the layer of epitaxial magnesium oxide; and
a second epitaxial overlayer of BaTiO₃ formed on said first epitaxial overlayer such that its crystallographic axes are aligned with the axes of at least one of the substrate, the layer of epitaxial magnesium oxide, and the first epitaxial overlayer.

10. A method of forming a semiconductor structure, comprising:
providing a tetrahedal compound semiconductor substrate; and
forming a layer (14;24;34) of epitaxial magnesium oxide on said substrate (12;22;32) such that its crystallographic axes are aligned with those of the substrate.
